# EUROPEAN PATENT SPECIFICATION

(11) **EP 1 469 349 B1**
(45) Date of publication and mention of the grant of the patent: **05.10.2011**
(21) Application number: 04076147.0
(22) Date of filing: 14.04.2004
(51) Int. Cl.: G03F 7/20

(54) **Lithographic projection apparatus with collector including a concave mirror and a convex mirror**
Lithographische Projektionsvorrichtung mit einem einen Konkavspiegel und einen Konvexspiegel aufweisenden Kollektor
Appareil de projection lithographique avec un collecteur comprenant un miroir concave et un miroir convexe

(30) Priority: 17.04.2003 EP 03076138
(43) Date of publication of application: 20.10.2004
(73) Proprietor: ASML Netherlands B.V., 5504 DR Veldhoven (NL)
(72) Inventor: Banine, Vadim Yevgenyevich, 5704 NK Helmond (NL)
(74) Representative: Slenders, Petrus J. W.

(56) References cited:
- EP-A- 1 274 287
- EP-A2- 1 031 882
- WO-A-99/03008
- US-A- 3 892 476
- US-A- 5 737 137
- US-A- 5 912 741
- US-A1- 2002 126 479
- PATENT ABSTRACTS OF JAPAN vol. 2000, no. 15, 6 April 2001 (2001-04-06) -& JP 2000 353418 A (CANON INC), 19 December 2000 (2000-12-19) -& US 6 639 652 B1 (MORI KENICHIRO ET AL) 28 October 2003 (2003-10-28)

## Description

The invention relates to a lithographic projection apparatus comprising a radiation source to produce radiation and at least one collector located in the vicinity of said radiation source for collecting said radiation to provide a beam of radiation.

Every lithographic projection apparatus has a radiation source. The radiation source provides illumination power. As this radiation source is mostly point like in shape, the radiation emitted by this radiation source is highly divergent in character. Therefore, collectors are used to focus the radiation into a more convergent radiation beam. Radiation that is not collected means a loss in illumination power. Hence, it is important to collect the radiation in as big a solid angle as possible. Multilayer (ML) collectors are able to collect radiation from such a small radiation source in a solid angle of more than 2 π sr (although practical angles are in between 1,4 π sr to 1,6 3 π sr) and provide a radiation beam. Presently, however, there is no adequate alternative for ML collectors available with a large collector angle.

It is therefore an aim of the present invention to disclose a lithographic projection apparatus with a collector that provides an EUV radiation beam with radiation collected from a solid angle which is in size comparable to the solid angle in which ML collectors collect radiation.

JP 2000 353418 A discloses (figures 1, 8) a lithographic projection apparatus according to the preamble of claim 1.

US5737137 discloses a critical illumination condenser system, particularly adapted for use in extreme ultraviolet (EUV) projection lithography based on a ring field imaging system and a laser produced plasma source. The system uses three spherical mirrors and is capable of illuminating the extent of the mask plane by scanning either the primary mirror or the laser plasma source. The angles of radiation incident upon each mirror of the critical illumination condenser vary by less than eight (8) degrees. For example, the imaging system in which the critical illumination condenser is utilized has a 200 µm source and requires a magnification of 26x. The three spherical mirror system constitutes a two mirror inverse Cassegrain, or Schwarzschild configuration, with a 25% area obstruction (50% linear obstruction). The third mirror provides the final pupil and image relay. The mirrors include a multilayer reflective coating which is reflective over a narrow bandwidth.

According to an aspect of the invention there is provided a lithographic projection apparatus comprising a radiation source to produce divergent radiation and at least one collector located in the vicinity of said radiation source for collecting said divergent radiation to provide a beam of radiation characterized in that said at least one collector comprises a first reflector having a concave surface and a second reflector having a convex surface, the first reflector surrounding the second reflector, said first reflector comprising a hole and said first reflector at least partly facing said second reflector, and the first reflector being arranged to receive said divergent radiation from said radiation source and reflect it directly to said second reflector to produce said beam of radiation, said beam of radiation, after being reflected by said second reflector exiting said collector via said hole. Collection of an amount of radiative power comparable to ML collectors is in this way possible.

The first reflector may be arranged so as to receive the divergent radiation directly from the radiation source.

Said at least one collector may be configured to focus the divergent radiation in a focal point.

Said second reflector may comprise field facets. This means that one mirror conventionally present in the illumination system downstream of the optical system may be omitted. When EUV radiation impinges on a mirror, about 30% of the radiative power is absorbed. Consequently, by omitting one mirror or mirrors, in the lithographic projection apparatus according to this embodiment of the invention substantially less radiative power is dissipated.

Said first reflector may comprise field facets and said second reflector may comprise pupil facets. Again, one or more mirror(s) less are needed in the (illumination) system downstream of the optical system which means that, consequently, a further reduction in the dissipation of radiative power in the lithographic projection apparatus may be obtained.

The lithographic projection apparatus may further comprise a contamination reduction device that is located between said radiation source and said at least one collector and is arranged to let said radiation pass through. A clean radiation beam is of paramount importance to obtain a lithographic projection with minimal irregularities (debris). The contamination reduction device (e.g. a foil trap) results in a reduced amount of debris in radiation downstream the contamination reduction device.

The invention also relates to a lithographic projection apparatus as described above comprising:
an optical system arranged to receive said beam of radiation and to produce a projection beam of radiation therefrom,
a support structure constructed to hold patterning means, to be irradiated by the projection beam to pattern said projection beam,
a substrate table constructed to hold a substrate, and
a projection system constructed and arranged to image an irradiated portion of the patterning means onto a target portion of the substrate.

The invention also relates to a method of manufacturing an integrated structure by a lithographic process by means of a lithographic projection apparatus as described above.

The term "patterning means" as employed above should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required; and
- A programmable LCD array. An example of such a construction is given in United States Patent US 5,229,872. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus ― commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm).

The invention will now be explained in connection with the accompanying drawings, which are only intended to show examples and not to limit the scope of protection, and in which:
Fig. 1 represents a schematic general overview of a lithographic projection apparatus;
Fig. 2 is a more detailed representation of an illuminator or illumination system (IL) of figure 1;
Fig. 3 is a representation of a ML collector used in the present state of the art;
Fig. 4 is a representation of a grazing incidence (GI) collector according to the present state of the art;
Fig. 5 is a collector according to the present invention;
Fig. 6 is a collector with field facets on the convex mirror; and
Fig. 7 is a collector with field facets on the concave mirror and pupil facets on the convex mirror.

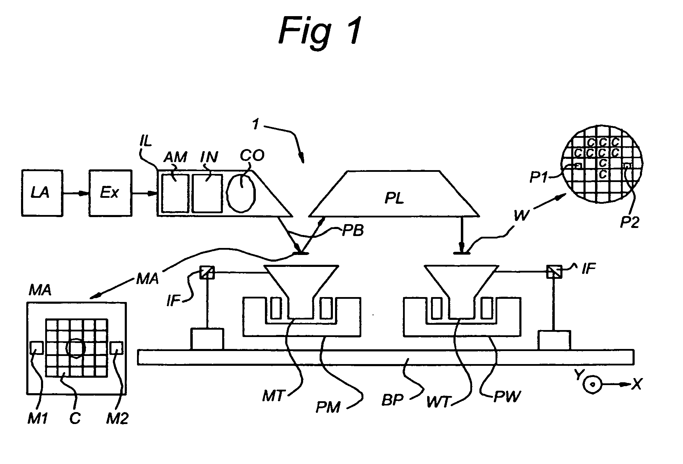

Fig. 1 schematically depicts a lithographic projection apparatus 1 according to a particular embodiment of the invention.

The apparatus comprises:
- a radiation system Ex, IL, for supplying a projection beam PB of radiation, among which all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm). In this particular case, the radiation system also comprises a radiation source LA;
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e.g. a resist-coated silicon wafer), and connected to second positioning means PW for accurately positioning the substrate with respect to item PL; and
- a projection system ("lens") PL for imaging an irradiated portion of the mask MA onto a target portion C (e.g. comprising one or more dies) of the substrate W.

As here depicted, the apparatus is of a reflective type (i.e. has a reflective mask). However, in general, it may also be of a transmissive type, for example (with a transmissive mask). Alternatively, the apparatus may employ another kind of patterning means, such as a programmable mirror array of a type as referred to above.

The source LA (e.g. a laser-produced plasma or a discharge plasma EUV radiation source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Fig. 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:
1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and
2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

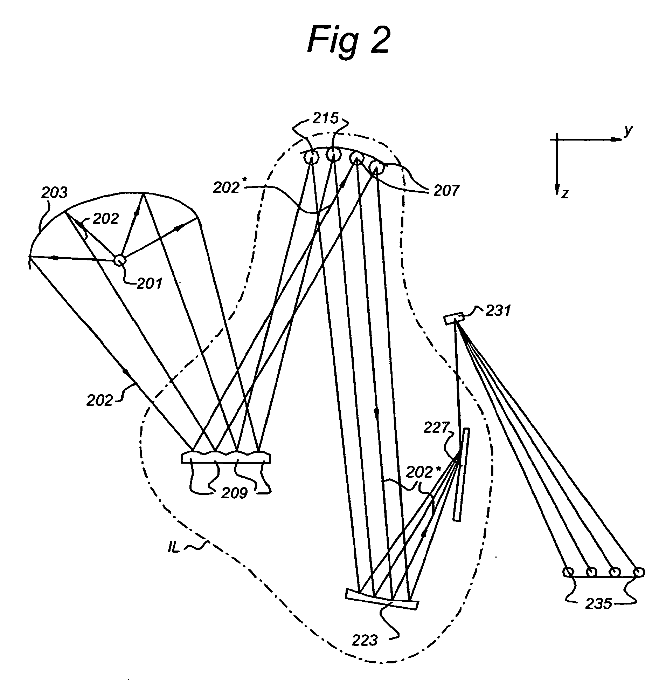

The illumination system IL is shown in greater detail in figure 2 which is based on figure 70 of US 6,438,199 B1. This system may be similar to the one described in detail in US 6,438,199, so that only an outline of this illumination system IL is described here.

The set up shown in figure 2 comprises a radiation source 201 from which radiation beams 202 originate. Behind the radiation source 201 a concave mirror 203 is located. In front of the radiation source tiny separate convex mirrors 209, so called field facets, are positioned. Each of the field facets 209 reflects the incoming radiation beam 202 towards a corresponding mirror 215. The mirrors 215 are also called pupil facets. Subsequently, the radiation beam 202 reflects onto a mirror 223 which is a concave mirror and onto a mirror 227 which is arranged at grazing incidence. The separate radiation beams 202 form separate images 235 of the radiation source 201 after reflection from patterning means located at 231.

The radiation beams 202 after leaving the source 201 are collected by the concave mirror 203 which is ellipsoidal of shape. The mirror 203 sends the radiation beams 202 towards the convex mirrors 209. Here the radiation beam is split into as many separate radiation beams 202* as there are mirrors 209. The convex mirror elements 209 reflect each radiation beam towards a particular pupil facet 215. The pupil facets 215 are arranged in the focus of the radiation beams 202*, thereby creating point like (secondary) sources which are indicated in figure 2 by reference numeral 207. Due to their position in the focus of the radiation beams 202*, the pupil facets may be designed as tiny planar mirrors. Alternatively, since the intensity of the radiation beams 202* in the focus can be quite high, the pupil facets 215 may be arranged out of focus.

However, as a rule of thumb, the distance between a secondary source 207 and a respective planar mirror must not be more than 20% of the distance between a convex mirrors 209 and a pupil facet 215 for a radiation beam 202*. Which particular convex mirror 209 reflects a radiation beam onto which pupil facet 215 is user defined. To this end the convex mirrors 209 and the pupil facets 215 may be individually tilted. The convex mirror 223 and the mirror 227 at grazing incidence function as collimating lens. The individual radiation beams 202* are superimposed at patterning means 231 and diverge after being reflected.

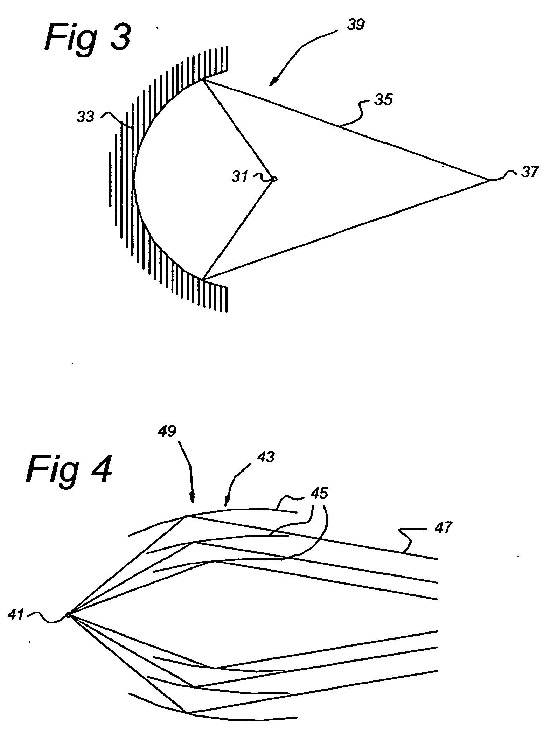

In fig. 3 an optical system 39, known as such, is shown that may be used to obtain a high intensity radiation beam 35 in a focal point 37. The optical system comprises a ML collector 33 and a radiation source 31.

The radiation from the radiation source 31 is reflected via the ML collector 33 into the focal point 37. This radiation is highly divergent in character, but depending on the location of the radiation source 31 and the shape of the ML collector 33, which in fig. 3 is shaped like half a sphere, radiation from a solid angle of about 2 π sr may be collected into the focal point 37.

In fig. 4 another optical system 49, known as such, to obtain a high intensity radiation beam 47 is shown. The system 49 comprises a radiation source 41. In the vicinity of the radiation source 41 a grazing incidence (GI) collector 43 is located. The GI collector 43 comprises several reflecting layers 45.

Radiation from the radiation source 41 is reflected against the layers 45 and focussed in a focal point (not shown). In this optical system 49 radiation from a solid angle less than 2π sr may be collected into the focal point. Grazing incidence (GI) collectors can be combined with contamination mitigating systems. However, a major drawback of GI collectors is that their radiation collecting angle is limited (1,1 π sr to 1,2 π sr) resulting in limited radiation yields.

### Embodiment 1

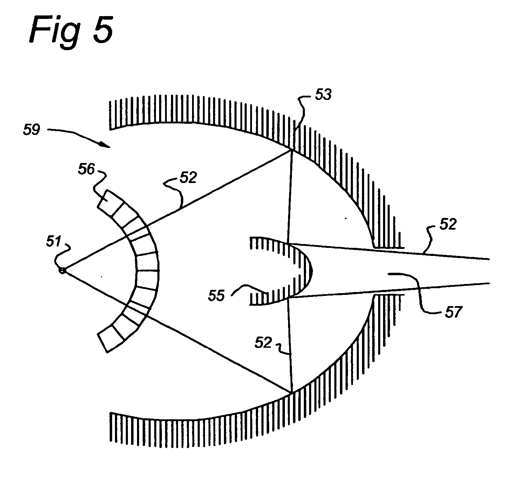

In fig. 5 an optical system comprising a collector 59 for a lithographic projection apparatus according to the present invention is shown. The system comprises a radiation source 51 radiating radiation 52 and a collector which looks like a Schwarzschild lens. The collector, however, is very different from a Schwarzschild lens. The collector comprises a convex mirror 55 (throughout this patent application also referred to as a second reflector on a convex surface) surrounded by a concave mirror 53 (throughout this patent application also referred to as a first reflector on a concave surface). In the concave mirror 53 a hole 57 is present.

Radiation 52 from the radiation source 51 is reflected first against the concave mirror 53 and then against the convex mirror 55. The radiation 52 exits the optical system 59 via the hole 57. The convex mirror 53, due to its particular shape and due to the location of the radiation source 51, collects radiation from a solid angle of about 2 π sr. The radiation 52 is focused in focal point 37 (not shown in figure 5).

### Embodiment 2

An important advantage is that in the set up as shown in fig. 5 it is possible to insert a contamination reduction device 56 in between the radiation source 51 and the concave mirror 55. This contamination reduction device 56 may be a foil trap, e.g., similar to one described in EP-A-1 223 468 and EP-A-1 057 079. After leaving the hole 57, the radiation 52 is directed to the illumination system IL, i.e., for instance to the field facets 209 of the illumination system IL shown in figure 2.

### Embodiment 3

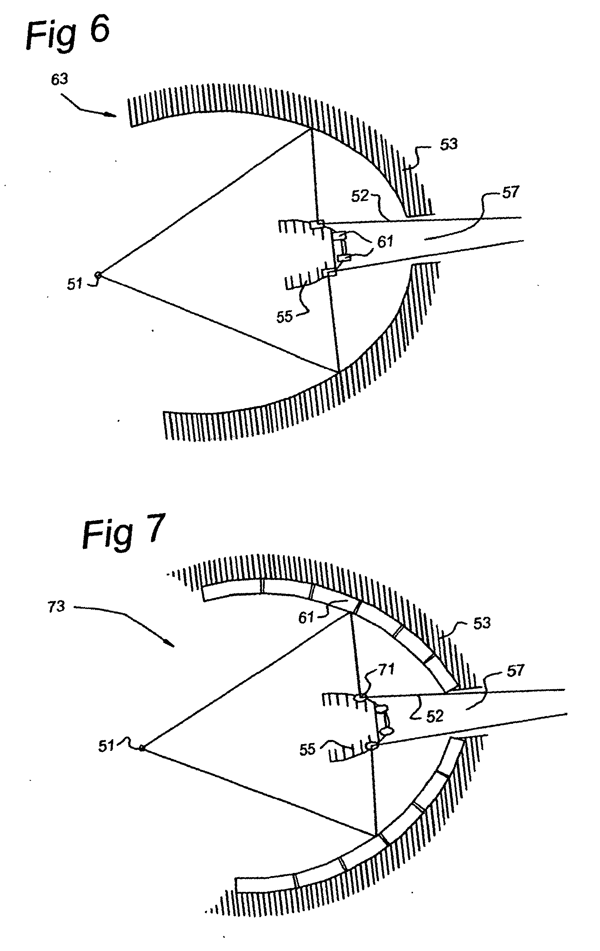

In fig. 6 the reference numerals corresponding to the reference numerals of fig. 5 refer to the same parts.

In fig. 6 field facets 61 are present on the convex mirror 55 of a collector 63. The field facets 61 decompose the radiation beam 52 into individual radiation sources with their origin in the individual field facets 61. Presently, this composition takes place in the illumination system (IL) as described in connection with fig. 2. By mounting the field facets 61 on the convex mirror 55, the field facets 209 downstream of the collector 63 may be omitted. This is especially advantageous, since every time the radiation beam hits a mirror, approximately 30 % of the radiation power is absorbed.

In fig. 7 reference numerals corresponding to the reference numerals of fig. 5 and 6 refer to the same parts. In fig. 7, field facets 61 are present on the concave mirror 53 of a collector 73 and pupil facets 71 are present on the convex mirror 55.

In this case, one more mirror less compared to the situation described in connection with fig. 6 is required which results in correspondingly more radiation power.

The collectors 59, 63 and 73 as described above have as an additional advantageous feature that they can be used in existing lithographic projection apparatus. I.e. the collector 33 shown in figure 3 and known as such may be exchanged for the collectors 59, 63 and 73 usable with the present invention without the need of changing the location of the radiation source 31 nor affecting the location of the focal point 37, when designed appropriately, as will be apparent to the skilled person.

## Claims

1. A lithographic projection apparatus comprising a radiation source (51) to produce divergent radiation and at least one collector (59; 63; 73) located in the vicinity of said radiation source (51) for collecting said divergent radiation to provide a beam of radiation (52), said at least one collector comprising a first reflector having a concave surface (53) and a second reflector having a convex surface (55), **characterized in that** said first reflector (53) is arranged to surround said second reflector (55), said first reflector comprising a hole (57) and said first reflector (53) at least partly facing said second reflector (55), and the first reflector (53) being arranged to receive said divergent radiation from said radiation source (51) and reflect it directly to said second reflector (55) to produce said beam of radiation (52), said beam of radiation (52), after being reflected by said second reflector (55) exiting said collector (59; 63; 73) via said hole (57).

2. Lithographic projection apparatus as claimed in claim 1, wherein the first reflector is arranged so as to receive the divergent radiation directly from the radiation source.

3. Lithographic projection apparatus as claimed in claim 1 or 2, wherein said at least one collector is configured to focus the divergent radiation in a focal point (37).

4. Lithographic projection apparatus according to claim 1 **characterized in that** said second reflector comprises field facets (61).

5. Lithographic projection apparatus according to claim 1 **characterized in that** said first reflector comprises field facets (61) and said second reflector comprises pupil facets (71).

6. Lithographic projection apparatus according to any of the preceding claims **characterized in that** said lithographic projection apparatus further comprises a contamination reduction device (56) that is located between said radiation source (51) and said at least one collector (59, 63, 73) and is arranged to let said radiation (52) pass through.

7. Lithographic projection apparatus (1) according to any of the preceding claims comprising:
an optical system arranged to receive said beam of radiation (52) and to produce a projection beam (PB) of radiation therefrom,
a support structure (MT) constructed to hold patterning means, to be irradiated by the projection beam to pattern said projection beam (PB),
a substrate table (WT) constructed to hold a substrate, and
a projection system (5) constructed and arranged to image an irradiated portion of the patterning means onto a target portion of the substrate.

8. Method of manufacturing an integrated structure by a lithographic process by means of a lithographic projection apparatus according to any of the preceding claims.

## Patentansprüche

1. Ein lithographisches Projektionsgerät, das eine Strahlungsquelle (51) zum Produzieren divergenter Strahlung und mindestens einen Kollektor (59; 63; 73), der in der Nähe der Strahlungsquelle (51) angeordnet ist, zum Sammeln der divergenten Strahlung beinhaltet, um einen Strahl aus Strahlung (52) bereitzustellen, wobei der mindestens eine Kollektor einen ersten Reflektor mit einer konkaven Oberfläche (53) und einen zweiten Reflektor mit einer konvexen Oberfläche (55) aufweist, **dadurch gekennzeichnet, dass** der erste Reflektor (53) eingerichtet ist, um den zweiten Reflektor (55) zu umgeben, wobei der erste Reflektor ein Loch (57) beinhaltet und der erste Reflektor (53) mindestens teilweise dem zweiten Reflektor (55) zugewandt ist und der erste Reflektor (53) eingerichtet ist, um die divergente Strahlung von der Strahlungsquelle (51) zu empfangen und sie direkt zu dem zweiten Reflektor (55) zu reflektieren, um den Strahl aus Strahlung (52) zu produzieren, wobei der Strahl aus Strahlung (52) nach seiner Reflektion durch den zweiten Reflektor (55) durch das Loch (57) aus dem Kollektor (59; 63; 73) austritt.

2. Lithographisches Projektionsgerät gemäß Anspruch 1, wobei der erste Reflektor eingerichtet ist, um die divergente Strahlung direkt von der Strahlungsquelle zu empfangen.

3. Lithographisches Projektionsgerät gemäß Anspruch 1 oder 2, wobei der mindestens eine Kollektor konfiguriert ist, um die divergente Strahlung in einem Brennpunkt (37) zu fokussieren.

4. Lithographisches Projektionsgerät gemäß Anspruch 1, **dadurch gekennzeichnet, dass** der zweite Reflektor Feldfacetten (61) beinhaltet.

5. Lithographisches Projektionsgerät gemäß Anspruch 1, **dadurch gekennzeichnet, dass** der erste Reflektor Feldfacetten (61) und der zweite Reflektor Pupillenfacetten (71) beinhaltet.

6. Lithographisches Projektionsgerät gemäß einem der vorhergehenden Ansprüche, **dadurch gekennzeichnet, dass** das lithographische Projektionsgerät ferner eine Kontaminationsreduktionsvorrichtung (56) beinhaltet, die zwischen der Strahlungsquelle (51) und dem mindestens einen Kollektor (59, 63, 73) angeordnet ist und eingerichtet ist, um die Strahlung (52) durchgehen zu lassen.

7. Lithographisches Projektionsgerät (1) gemäß einem der vorhergehenden Ansprüche, das Folgendes beinhaltet:
ein optisches System, das eingerichtet ist, um den Strahl aus Strahlung (52) zu empfangen und daraus einen Projektionsstrahl (PB) aus Strahlung zu produzieren,
eine Stützstruktur (MT), die konstruiert ist, um ein Musteraufbringungsmittel zu halten, das von dem Projektionsstrahl bestrahlt werden soll, um den Projektionsstrahl (PB) zu mustern,
einen Substrattisch (WT), der konstruiert ist, um ein Substrat zu halten, und
ein Projektionssystem (5), das konstruiert und eingerichtet ist,
um einen bestrahlten Abschnitt des Musteraufbringungsmittels auf einem Zielabschnitt des Substrats abzubilden.

8. Ein Verfahren zum Herstellen einer integrierten Struktur durch einen lithographischen Prozess mittels eines lithographischen Projektionsgeräts gemäß einem der vorhergehenden Ansprüche.

## Revendications

1. Un appareil de projection lithographique comprenant une source de rayonnement (51) afin de produire un rayonnement divergent et au moins un collecteur (59 ; 63 ; 73) situé au voisinage de ladite source de rayonnement (51) pour collecter ledit rayonnement divergent afin de fournir un faisceau de rayonnement (52), ledit au moins un collecteur comprenant un premier réflecteur ayant une surface concave (53) et un deuxième réflecteur ayant une surface convexe (55), **caractérisé en ce que** ledit premier réflecteur (53) est arrangé pour entourer ledit deuxième réflecteur (55), ledit premier réflecteur comprenant un trou (57) et ledit premier réflecteur (53) faisant au moins en partie face audit deuxième réflecteur (55), et le premier réflecteur (53) étant arrangé pour recevoir ledit rayonnement divergent de ladite source de rayonnement (51) et le réfléchir directement vers ledit deuxième réflecteur (55) afin de produire ledit faisceau de rayonnement (52), ledit faisceau de rayonnement (52), une fois réfléchi par ledit deuxième réflecteur (55), sortant dudit collecteur (59 ; 63 ; 73) par ledit trou (57).

2. Appareil de projection lithographique tel que revendiqué dans la revendication 1, dans lequel le premier réflecteur est arrangé de manière à recevoir le rayonnement divergent directement de la source de rayonnement.

3. Appareil de projection lithographique tel que revendiqué dans la revendication 1 ou la revendication 2, dans lequel ledit au moins un collecteur est configuré pour concentrer le rayonnement divergent en un point focal (37).

4. Appareil de projection lithographique selon la revendication 1 **caractérisé en ce que** ledit deuxième réflecteur comprend des facettes de champ (61).

5. Appareil de projection lithographique selon la revendication 1 **caractérisé en ce que** ledit premier réflecteur comprend des facettes de champ (61) et ledit deuxième réflecteur comprend des facettes de pupille (71).

6. Appareil de projection lithographique selon n'importe lesquelles des revendications précédentes **caractérisé en ce que** ledit appareil de projection lithographique comprend en outre un dispositif de réduction de contamination (56) qui est situé entre ladite source de rayonnement (51) et ledit au moins un collecteur (59, 63, 73) et qui est arrangé pour laisser ledit rayonnement (52) passer au travers.

7. Appareil de projection lithographique (1) selon n'importe lesquelles des revendications précédentes comprenant :
un système optique arrangé pour recevoir ledit faisceau de rayonnement (52) et pour produire un faisceau de projection (PB) de rayonnement à partir de celui-ci,
une structure formant support (MT) construite pour porter un moyen servant à conformer selon un motif, devant être irradié par le faisceau de projection afin de conformer ledit faisceau de projection (PB) selon un motif,
une table porte-substrat (WT) construite pour porter un substrat, et
un système de projection (5) construit et arrangé pour imager une portion irradiée du moyen servant à conformer selon un motif sur une portion cible du substrat.

8. Procédé de fabrication d'une structure intégrée par un processus lithographique au moyen d'un appareil de projection lithographique selon n'importe lesquelles des revendications précédentes.
